# EUROPÄISCHE PATENTSCHRIFT

(11) **EP 1 621 918 B1**
(45) Veröffentlichungstag und Bekanntmachung des Hinweises auf die Patenterteilung: **20.10.2010**
(21) Anmeldenummer: 05015789.0
(22) Anmeldetag: 20.07.2005
(51) Int. Cl.: G02B 27/00, G02B 27/09, G09F 19/22, F21V 5/04

(54) **Leuchtdiodenanordnung zur gleichmässigen Ausleuchtung einerrechteckigen Fläche und Notbeleuchtung**
Arrangement of light emitting diode allowing for uniform illumination of a rectangular area and emergency illumination
Dispositif comprenant des diodes lumineuses permettant l'illumination homogène d'une zone rectangulaire et illumination de secours

(30) Priorität: 02.09.2004 DE 102004042561; 20.07.2004 DE 102004035127
(43) Veröffentlichungstag der Anmeldung: 01.02.2006
(73) Patentinhaber: OSRAM Opto Semiconductors GmbH, 93055 Regensburg (DE)
(72) Erfinder: Blümel, Simon, 84069 Schierling (DE)
(74) Vertreter: Epping - Hermann - Fischer

(56) Entgegenhaltungen:
- EP-A- 0 987 577
- US-A1- 2001 007 527
- US-A1- 2002 080 615
- US-A1- 2003 161 137
- US-A1- 2004 062 055

## Beschreibung

Die Erfindung betrifft eine Leuchtdiodenanordnung und eine Notbeleuchtung.

Die Druckschrift US 6,741,324 B1 beschreibt eine Fluchtweg- und Notfallbeleuchtung, die zwei Leuchten aufweist. Beide Leuchten können jeweils eine Leuchtdiode mit einer der Leuchtdiode nachgeordneten Linse aufweisen.

Die Druckschrift US 5,485,317 betrifft ein optisches System für lichtemittierende Dioden. Die Diode ist fixiert auf der optischen Achse einer Trägerlinse mit einem Vorderbereich, der eine quer verlaufende konkave Oberfläche hat und einem longitudinalen Bereich zur Aufnahme der Diode.

Aufgabe der vorliegenden Erfindung ist es, eine Leuchtdiodenanordnung sowie eine entsprechende Notbeleuchtung auzugeben, die eine möglichst, gleichmäßige und effiziente Ausleuchtung eines rechteckigen Gebiets erlaubt. Diese Aufgabe wird gelöst durch die Gegenstände der Ansprüche 1 und 7. Vorteilhafte Ausgestaltungen sind Gegenstand von Unteransprüchen.

Angegeben wird eine Leuchtdiode (LED) umfassend ein optisches Element mit einer rechteckigen Strahlungseintrittsfläche und einer Strahlungsaustrittsfläche, die auf der zur Strahlungseintrittsfläche gegenüberliegenden Seite des optischen Elementes angeordnet ist. Die Strahlungsaustrittsfläche weist wobei einen konkav gekrümmten Teilbereich in der Mitte der Strahlungsaustrittsfläche und zwei konvex gekrümmte Teilbereiche auf, die den konkav gekrümmten Teilbereich seitlich einschließen. Weiterhin umfasst die LED-Anordnung wenigstens eine Leuchtdiode, die so angeordnet ist, dass die Strahlungseintrittsfläche des optischen Elements der LED in einer Hauptabstrahlrichtung nachgeordnet und zentriert zum konkav gekrümmten Teilbereich angeordnet ist. Seitlich am optischen Element sind reflektierende Flächen angeordnet. Senkrecht zu den reflektierenden Flächen sind Seitenflächen zwischen der Strahlungseintrittsfläche und der Strahlungsaustrittsfläche angeordnet, deren Form einem zusammengesetzten parabolischen Konzentrator, einem zusammengesetzten elliptischen Konzentrator oder einem zusammengesetzten hyperpolischen Konzentrator entspricht, wobei sich der jeweilige Konzentrator zur Strahlungseintrittsfläche hin verjüngt. Weiterhin ist eine Draufsicht auf die Strahlungsaustrittsfläche rechteckig.

Das optische Element weist einen Körper und eine Strahlungsaustrittsfläche auf. Die Strahlungsaustrittsfläche ist bevorzugt derart geformt, dass vom Körper des optischen Elements durch die Strahlungsaustrittsfläche austretendes Licht geeignet ist, ein vorgegebenes Gebiet aus vorgegebenem Abstand im Wesentlichen gleichmäßig auszuleuchten.

Die Form der Strahlungsaustrittsfläche erlaubt dabei eine im Wesentlichen gleichmäßige Verteilung des Lichts auf das zu beleuchtende Gebiet. Eine im Wesentlichen gleichmäßige Ausleuchtung des Gebiets bedeutet dabei, dass die Beleuchtungsstärke, gemessen auf der beleuchteten Fläche, im Wesentlichen konstant ist. Das heißt die Beleuchtungsstärke an der hellsten Stelle des vorgegebenen Gebiets ist maximal um 50% größer als an der dunkelsten Stelle des Gebiets, bevorzugt ist sie maximal um 25%, besonders bevorzugt maximal um 10% größer.

Am Rand des vorgegebenen Gebietes fällt die Beleuchtungsstärke bevorzugt stark ab, sodass dort steile Flanken der Beleuchtungsstärke vorhanden sind. Bevorzugt wird also hauptsächlich das vorgegebene Gebiet ausgeleuchtet.

Die Abstrahlcharakteristik eines Strahlung aussendenden Elements, dessen Strahlung in das optische Element eingekoppelt ist, wird nicht vom optischen Element in die auszuleuchtende Fläche abgebildet. Das heißt, bei dem optischen Element handelt es sich um eine nicht abbildende Optik.

Zusammenfassend wird also ein optisches Element angegeben mit einer Strahlungsaustrittsfläche, die derart geformt ist, dass vom Körper des optischen Elements durch die Strahlungsaustrittsfläche austretendes Licht geeignet ist, ein vorgegebenes Gebiet aus vorgegebenem Abstand im wesentlichen gleichmäßig auszuleuchten.

In einer Ausführungsform des optischen Elements weist das optische Element eine Strahlungseintrittsfläche und eine Strahlungsaustrittsfläche auf. Die Strahlungsaustrittsfläche ist auf der zur Strahlungseintrittsfläche gegenüberliegenden Seite des optischen Elements angeordnet. Das heißt, eine beispielsweise senkrecht zur Strahlungseintrittsfläche in das optische Element eingekoppelte elektromagnetische Strahlung tritt durch die Strahlungsaustrittsfläche aus dem optischen Element wieder aus.

Die Strahlungsaustrittsfläche des optischen Elements weist einen konkav und zwei konvex gekrümmte Teilbereiche auf. Konkav gekrümmt heißt dabei, dass die Strahlungsaustrittsfläche des optischen Elements im konkav gekrümmten Teilbereich nach innen gekrümmt ist, konvex bedeutet, dass die Strahlungsaustrittsfläche im konvexen Teilbereich nach außen gekrümmt ist. Aufgrund der Krümmung der Strahlungsaustrittsfläche wird Licht beim Austritt durch die Strahlungsaustrittsfläche bevorzugt derart gebrochen, dass eine möglichst gleichmäßige Verteilung der Beleuchtungsstärke auf das auszuleuchtende Gebiet erreicht wird.

Weiterhin ist der konkav gekrümmter Teilbereich der Strahlungsaustrittsfläche in der Mitte der Strahlungsaustrittsfläche angeordnet. Das heißt, beispielsweise ist die Strahlungsaustrittsfläche so geformt, dass sie einen geometrischen Mittelpunkt aufweist. Der konkav gekrümmte Teilbereich ist dann bevorzugt derart angeordnet, dass er den Mittelpunkt der Strahlungsaustrittsfläche beinhaltet. Besonders bevorzugt ist der konkav gekrümmte Teilbereich derart angeordnet, dass der geometrische Mittelpunkt der Strahlungsaustrittsfläche und das lokale Minimum des konkav gekrümmten Bereichs zusammenfallen.

Weiterhin ist der konkav gekrümmte Teilbereich zu dem konvex gekrümmten Teilbereichen benachbart angeordnet.

Das heißt, beim Überfahren der Strahlungsaustrittsfläche, ausgehend von einem konkav gekrümmten Teilbereich, schließt sich in wenigstens zwei Raumrichtungen jeweils ein konvex gekrümmter Teilbereich an.

Weiterhin entspricht eine Draufsicht auf die Strahlungsaustrittsfläche im Wesentlichen der Form des auszuleuchtenden Gebiets. Das heißt, die in eine Ebene projizierte Form der Strahlungsaustrittsfläche kann der Form des auszuleuchtenden Gebiets angepasst sein. Die Ebene kann dabei beispielsweise die Ebene des vorgegebenen Gebiets sein. Bevorzugt verläuft die Ebene auch parallel zu Strahlungseinstrittsfläche.

Zweckmäßigerweise sind die ebene Fläche, die durch die Umrandung der Strahlungsaustrittsfläche definiert ist, und die homogen auszuleuchtende Fläche geometrisch ähnlich zueinander. Wenn das auszuleuchtende Gebiet beispielsweise von rechteckiger Form ist, so ist auch die durch die Umrandung der Strahlungsaustrittsfläche definierte ebene Fläche des optischen Elements rechteckig. Zudem weist diese Fläche dann das gleiche Seitenverhältnis wie das auszuleuchtende Gebiet auf. Die tatsächliche Größe der durch die Umrandung der Strahlungsaustrittsfläche begrenzten Fläche ist dann zusätzlich, zum Beispiel, noch durch den Abstand zum zu beleuchtenden Gebiet bestimmt.

Weiterhin weist das optische Element wenigstens eine Fläche auf, die zwischen Strahlungseintrittsfläche und Strahlungsaustrittsfläche angeordnet ist und die reflektierend ausgestaltet ist. Das heißt, Strahlung, die durch die Strahlungseintrittsfläche in das optische Element eingekoppelt ist, kann beim Durchgang durch das optische Element an dieser Fläche reflektiert werden. Auf diese Weise lässt sich ein Lichtaustritt durch diese Fläche verhindern. Die reflektierende Fläche trägt damit dazu bei, dass vor allem das vorgegebene Gebiet möglichst homogen ausgeleuchtet ist. In angrenzenden Bereichen kann die Beleuchtungsstärke stark verringert sein. Damit wird die Effizienz des optischen Elements gesteigert, da das zur Verfügung stehende Licht im Wesentlichen zur Beleuchtung des vorgegebenen Gebiets genutzt wird.

Beispielsweise ist die Fläche reflektierend beschichtet oder die Reflexion an der Fläche erfolgt auf Grund von Totalreflexion. Beispielsweise sind alle Seitenflächen des optischen Elements, d.h. alle Flächen, die zwischen Strahlungseintrittsfläche und Strahlungsaustrittsfläche des optischen Elements angeordnet sind, reflektierend ausgebildet.

Alternativ zu dem optischen Element gemäß Patentanspruch 1 kann wenigstens eine weitere Strahlungsaustrittsfläche zwischen Strahlungseintrittsfläche und Strahlungsaustrittsfläche angeordnet sein. Diese Strahlungsaustrittsfläche kann beispielsweise so angeordnet sein, dass Randbereiche des vorgegebenen Gebiets besser ausgeleuchtet werden, um eine gleichmäßigere Ausleuchtung des Gebiets zu erreichen. Bevorzugt weist diese Strahlungsaustrittsfläche keine konkav oder konvex gekrümmten Teilbereiche auf, sondern ist entweder gleichmäßig gekrümmt oder verläuft im Wesentlichen gerade. Beispielsweise handelt es sich bei der Fläche um eine Seitenfläche des optischen Elements, die Strahlungsaustrittsfläche und Strahlungseintrittsfläche des optischen Elements miteinander verbindet.

In einer weiteren Ausführungsform des optischen Elements ist das optische Element aus einem transparenten Material gebildet. Bevorzugt weist das Material einen Brechungsindex auf, der größer ist als der Brechungsindex des Materials, das an die erste Strahlungsaustrittsfläche grenzt. Das heißt, Lichtstrahlen, die das optische Element beispielsweise durch die erste Strahlungsaustrittsfläche verlassen, treten vom optisch dichteren ins optisch dünnere Medium aus und werden an der Strahlungsaustrittsfläche gemäß den Gesetzen der geometrischen Optik gebrochen. Krümmung der Strahlungsaustrittsfläche und Brechungsindex des optischen Elements sind dabei bevorzugt derart zueinander angepasst, dass eine im Wesentlichen gleichmäßige Ausleuchtung des vorgegebenen Gebiets gegeben ist. Bevorzugt enthält das optische Element dabei ein Material, das einen Brechungsindex größer n = 1,3 aufweist. Besonders bevorzugt enthält das optische Element eines der folgenden Materialien: Plexiglas, Glas, Polykarbonat. Es sind aber auch andere transparente Materialien wie beispielsweise Kunststoffe zur Bildung des optischen Elements denkbar.

Die Leuchtdiode ist so angeordnet, dass die Strahlungseintrittsfläche des optischen Elements der Leuchtdiode in einer Hauptabstrahlrichtung der Leuchtdiode nachgeordnet ist. Das heißt, ein überwiegender Anteil des von der Leuchtdiode abgegebenen Lichts wird durch die Strahlungseintrittsfläche in das optische Element eingekoppelt. Zwischen Leuchtdiode und optischem Element kann dazu ein Spalt angeordnet sein, der beispielsweise Luft enthält. Es ist aber auch möglich, dass das optische Element auf ein Vergussmaterial, das beispielsweise den Leuchtdiodenchip umgibt, aufgeklebt ist.

Bevorzugt handelt es sich bei der Leuchtdiode um eine oberflächenmontierbare Leuchtdiode. Bei einer solchen Leuchtdiode kann das optische Element besonders nahe am Leuchtdiodenchip angeordnet sein, sodass ein besonders großer Anteil der von der Leuchtdiode abgegebenen elektromagnetischen Strahlung durch die Strahlungseintrittsfläche in das optische Element eingekoppelt wird.

Weiterhin ist die Leuchtdiode zentriert zu dem konkav gekrümmten Teilbereich der Strahlungsaustrittsfläche des optischen Elements angeordnet. Auf diese Weise kann von der Leuchtdiode durch die Strahlungseintrittsfläche in das optische Element eingekoppelte elektromagnetische Strahlung besonders gleichmäßig auf dem vorgegebenen Gebiet verteilt werden. Die Strahlung wird beispielsweise vom konkav gekrümmten Teilbereich zu benachbarten Bereichen der Strahlungsaustrittsfläche, die seitlich vom konkav gekrümmten Teilbereich gelegen sind, gebrochen. Dadurch ist erreicht, dass auf dem vorgegebenen Gebiet kein ausgeprägtes Maximum, beispielsweise verursacht durch eine annähernd punktförmige Lichtquelle, wahrnehmbar ist.

In einer Ausführungsform der Leuchtdiodenanordnung weist der Leuchtdiodenchip der Leuchtdiode eine Strahlungsauskoppelfläche auf, die der Strahlungseintrittsfläche des optischen Elements gegenüberliegend angeordnet ist. Bevorzugt tritt ein Großteil der im Leuchtdiodenchip erzeugten elektromagnetischen Strahlung durch die Strahlungsauskoppelfläche des Leuchtdiodenchips aus. Besonders bevorzugt tritt die Strahlung ausschließlich durch die Strahlungsauskoppelfläche aus. Dadurch ist erreicht, dass möglichst wenig Strahlung vor dem Eintritt in das optische Element seitlich abgestrahlt wird und auf diese Weise für die Ausleuchtung des vorgegebenen Gebiets verloren geht.

Bevorzugt enthält der Leuchtdiodenchip einen epitaktisch gewachsenen Schichtstapel. Der Schichtstapel ist beispielsweise eine Abfolge von epitaktisch gewachsenen Schichten. Bevorzugt umfasst der Schichtstapel wenigstens eine aktive Zone, die zur Erzeugung elektromagnetischer Strahlung geeignet ist. Die aktive Zone ist bevorzugt zur Erzeugung von elektromagnetischer Strahlung im blauen oder ultravioletten Spektralbereich geeignet.

Dazu kann die aktive Zone beispielsweise einen pn-Übergang, eine Doppelheterostruktur, eine Einfachquantentopf- oder besonders bevorzugt eine Mehrfachquantentopfstruktur (MQW) aufweisen.

Die Bezeichnung Quantentopfstruktur umfasst im Rahmen der Anmeldung jegliche Struktur, bei der Ladungsträger durch Einschluss ("confinement") eine Quantisierung ihrer Energiezustände erfahren. Insbesondere beinhaltet die Bezeichnung Quantentopfstruktur keine Angabe über die Dimensionalität der Quantisierung. Sie umfasst somit u.a. Quantentröge, Quantendrähte und Quantenpunkte und jede Kombination dieser Strukturen.

Der Schichtstapel ist besonders bevorzugt eine Abfolge von epitaktisch gewachsenen Schichten, von denen das Aufwachssubstrat nach Abschluss des epitaktischen Wachstums entfernt worden ist. Besonders bevorzugt ist auf die dem ursprünglichen Aufwachssubstrat abgewandte Oberfläche des Schichtstapels ein Träger aufgebracht. Bauteile, die unter Entfernen des Aufwachssubstrats von einer epitaktisch gewachsenen Schichtfolge hergestellt sind, werden oftmals auch mit dem Oberbegriff Dünnfilmschicht-Bauteile bezeichnet.

Ein Grundprinzip eines Dünnfilmschicht-Bauteils ist beispielsweise in I. Schnitzer et al., Appl. Phys. Lett. 63(16), 18. Oktober 1993, Seiten 2174-2176, beschrieben, deren Offenbarungsgehalt bezüglich des Grundprinzips von Dünnfilmschicht-Bauteilen hiermit durch Rückbezug aufgenommen wird.

Eine Dünnfilmleuchtdiode ist in guter Näherung ein Lambert'scher Oberflächenstrahler und eignet sich von daher besonders gut, beispielsweise für die Anwendung in einem Scheinwerfer.

Besonders vorteilhaft ist, dass der Träger verglichen mit dem Aufwachssubstrat, relativ frei gewählt werden kann. So kann der Träger hinsichtlich mancher Eigenschaften wie etwa Leitfähigkeit, Stabilität oder thermischen Ausdehnungskoeffizienten für das Bauteil besser geeignet sein als verfügbare Aufwachssubstrate, die zur Herstellung hochwertiger, epitaktisch gewachsener Schichtfolgen engen Einschränkungen unterliegen. So muss, um hochwertige epitaktische Schichten zu erhalten, das epitaktisch abgeschiedene Material beispielsweise gitterangepasst zum Aufwachssubstrat sein.

Gemäß einer bevorzugten Ausgestaltung des Leuchtdiodenchips ist zwischen dem aufgebrachten Träger und dem Schichtstapel eine Spiegelschicht angeordnet. Die Spiegelschicht kann beispielsweise einen Bragg-Spiegel oder eine metallhaltige Spiegelschicht umfassen. Ein metallhaltiger Spiegel, der beispielsweise Gold, Gold-Germanium, Silber, Aluminium oder Platin enthalten kann, zeichnet sich gegenüber einem Bragg-Spiegel beispielsweise durch eine geringere Richtungsabhängigkeit der Reflektivität aus. Auch lässt sich mit metallhaltigen Spiegeln eine höhere Reflektivität als mit Bragg-Spiegeln erreichen.

Bevorzugt ist dem Leuchtdiodenchip ein Konversionsmaterial nachgeordnet, das geeignet ist, zumindest einen Teil der im Leuchtdiodenchip erzeugten elektromagnetischen Strahlung in elektromagnetische Strahlung einer größeren Wellenlänge zu konvertieren. Auf diese Weise ist es beispielsweise möglich, dass vom Leuchtdiodenchip erzeugtes blaues Licht sich mit wellenlängenkonvertiertem gelbem Licht zu weißem Licht mischt. Geeignete Lumineszenz-Konversionsmaterialien sind beispielsweise in der Druckschrift WO98/12757 beschrieben, deren Inhalt insofern hiermit durch Rückbezug aufgenommen wird. Das Konversionsmaterial kann beispielsweise in der Vergussmasse, die den Leuchtdiodenchip umgibt vorhanden sein. Das Konversionsmaterial kann aber auch im optischen Element vorhanden sein.

In einer weiteren Ausführungsform der Leuchtdiodenanordnung weist die Leuchtdiode eine elektrische Leistungsaufnahme zwischen 1 und 2 W auf. Bevorzugt liegt der optische Wirkungsgrad der Leuchtdiode dabei zwischen 15 und 25 lm/W. Besonders bevorzugt beträgt der Wirkungsgrad der Leuchtdiode mehr als 25 lm/W.

In einer weiteren Ausführungsform der Leuchtdiodenanordnung ist die Leuchtdiodenanordnung geeignet, eine Fläche von wenigstens 16 m² mit einer mittleren Beleuchtungsstärke von wenigstens 1 Lux auszuleuchten. Besonders bevorzugt wird die Fläche mit im Wesentlichen homogener Beleuchtungsstärke von wenigstens 1 Lux ausgeleuchtet.

Es wird ferner eine Notbeleuchtung angegeben, aufweisend eine der oben beschriebenen Leuchtdiodenanordnungen sowie eine netzunabhängige Stromversorgung. Bei der netzunabhängigen Stromversorgung kann es sich beispielsweise um handelsübliche aufladbare Batterien handeln, die zusammen mit der Leuchtdiodenanordnung beispielsweise in einem Gehäuse angeordnet sind. Es ist aber auch möglich, dass die Leuchtdiodenanordnung über das hausinterne Stromnetz angeschlossen ist und im Falle eines Stromausfalls über Notstromaggregate betrieben wird.

Der Einsatz von Leuchtdioden für Notleuchtsysteme ermöglicht dabei vorteilhaft Leuchten mit hoher Lebensdauer. Durch Verwendung einer beschriebenen optimierten Optik kann die Anzahl der notwendigen Lichtquellen deutlich reduziert werden, wobei trotzdem die Forderung nach einer minimalen Beleuchtungsstärke beispielsweise gemäß der Arbeitsstättenverordnung, § 7, Abschnitt (4) erfüllt ist, wonach die Notfallbeleuchtung wenigstens eine Beleuchtungsstärke von 1 Lux aufweisen muss. Durch die optimale Ausnutzung des zur Verfügung stehenden Lichts der Leuchte mit Hilfe der optimierten Optik ist der Aufbau von Leuchten möglich, die eine sehr geringe Leistungsaufnahme besitzen. Damit ist der Einsatz von sehr kleinen dezentralen Akkumulatoren möglich.

Im Folgenden werden das hier beschriebene optische Element sowie die hier beschriebene Leuchtdiodenanordnung anhand von Ausführungsbeispielen und den dazugehörigen Figuren näher erläutert.
Figur 1 zeigt eine perspektivische Prinzipskizze eines ersten Ausführungsbeispiels des hier beschriebenen optischen Elements.
Figur 2 zeigt eine schematische Schnittdarstellung eines Ausführungsbeispiels der hier beschriebenen optischen Anordnung.
Figur 3a zeigt die gemessene Beleuchtungsstärke für ein Ausführungsbeispiel der hier beschriebenen Leuchtdiodenanordnung.
Figur 3b zeigt schematisch die Anordnung eines Ausführungsbeispiels der hier beschriebenen Leuchtdiodenanordnung zum auszuleuchtenden Gebiet.
Figur 4a zeigt eine schematische Draufsicht auf die Strahlungsauskoppelfläche eines Ausführungsbeispiels des hier beschriebenen optischen Elements.
Figur 4b zeigt eine schematische Draufsicht auf eine alternative Strahlungsauskoppelfläche des hier beschriebenen optischen Elements.
Figur 4c zeigt eine schematische Draufsicht auf eine alternative Strahlungsauskoppelfläche eines hier beschriebenen optischen Elements.
Figur 5A zeigt eine schematische Schnittdarstellung eines Ausführungsbeispiels der hier beschriebenen optischen Anordnung.
Figur 5B zeigt eine schematische Schnittdarstellung eines Ausführungsbeispiels der hier beschriebenen optischen Anordnung in einem Schnitt entlang der Strahlungseintrittsfläche 1.

In den Ausführungsbeispielen und Figuren sind gleiche oder gleich wirkende Bestandteile jeweils mit den gleichen Bezugszeichen versehen. Die dargestellten Bestandteile sowie die Größenverhältnisse der Bestandteile untereinander sind nicht als maßstabsgerecht anzusehen. Vielmehr sind einige Details der Figuren zum besseren Verständnis übertrieben groß dargestellt.

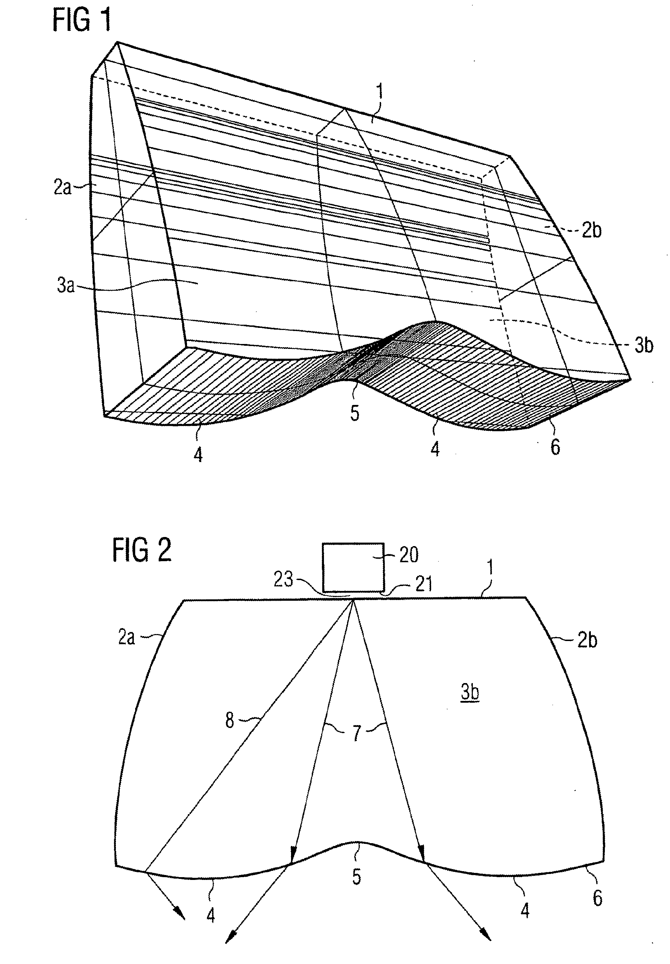

Figur 1 zeigt eine perspektivische Prinzipskizze des hier beschriebenen optischen Elements. Das optische Element weist eine Strahlungseintrittsfläche 1 auf, durch die elektromagnetische Strahlung in das optische Element eingekoppelt werden kann. Die Strahlungseintrittsfläche ist beispielsweise durch eine rechteckige Fläche gegeben, die etwa 4 cm lang und etwa 0,25 cm breit ist.

Seitlich am optischen Element befinden sich beispielsweise reflektierende Flächen 2a, b. Die Reflexion der im optischen Element verlaufenden Strahlung kann beispielsweise durch Totalreflexion an den reflektierenden Flächen 2a, 2b erfolgen. Es ist aber auch möglich, dass die reflektierenden Flächen 2a, b durch eine Beschichtung der Seitenflächen, beispielsweise mit einem Metall, gebildet sind. Beispielsweise können die Seitenflächen dazu mit Silber beschichtet sein.

Durch die senkrecht zu den reflektierenden Flächen 2a, 2b verlaufenden seitlichen Strahlungsaustrittsflächen 3a, b kann Strahlung aus dem optischen Element austreten, sofern die Bedingung für Totalreflexion für die Strahlung nicht erfüllt ist. Das austretende Licht trägt dabei vor allem zur Ausleuchtung der Randbereiche des vorgegebenen Gebiets bei. Das heißt, auch die Seitenflächen 3a, 3b sind reflektierend ausgestaltet. Bevorzugt erfolgt die Reflexion von elektromagnetischer Strahlung dort mittels Totalreflexionen. Zu divergente Strahlung, die die Bedingung für Totalreflexion nicht erfüllt, tritt durch die Seitenflächen 3a, 3b aus.

Der Großteil der durch die Strahlungseintrittsfläche 1 in das optische Element eintretenden Strahlung wird jedoch durch die Strahlungsaustrittsfläche 6 aus dem optischen Element ausgekoppelt. Diese Strahlungsaustrittsfläche ist beispielsweise 4 cm lang und 1 cm breit.

Die Strahlungsaustrittsfläche 6 weist dabei beispielsweise einen konkav gekrümmten Teilbereich 5 in der Mitte der Strahlungsaustrittsfläche 6 und zwei konvex gekrümmte Teilbereiche 4 auf, die den konkav gekrümmten Teilbereich 5 seitlich einschließen. Der konkav gekrümmte Teilbereich 5 ist beispielsweise im geometrischen Zentrum der Strahlungsaustrittsfläche 6 angeordnet.

Das optische Element ist beispielsweise aus Polykarbonat, Glas oder Plexiglas gebildet. Bevorzugt ist es durch ein Spritzguss- oder Spritzpressverfahren hergestellt. Dies erlaubt eine besonders kostengünstige Produktion des optischen Elements. Weitere mögliche Materialien zur Bildung des optischen Elements sind PMMA, PMMI und/oder COC.

Figur 2 zeigt schematisch eine Schnittdarstellung einer Leuchtdiodenanordnung, aufweisend ein optisches Element, wie es beispielsweise in Figur 1 beschrieben ist. Eine Leuchtdiode 20 ist mit ihrer Strahlungsauskoppelfläche 21 der Strahlungseintrittsfläche 1 des optischen Elements zugewandt. Bevorzugt ist die Leuchtdiode 20 zum konkav gekrümmten Bereich 5 zentriert angeordnet. Die Leuchtdiode weist bevorzugt eine Leistungsaufnahme von ca. 1,5 W auf und hat einen Wirkungsgrad von ca. 21 lm/W.

Zwischen Strahlungseintrittsfläche 1 und Strahlungsauskoppelfläche 21 der Leuchtdiode 20 ist ein beispielsweise mit Luft gefüllter Spalt 23 vorhanden.

Die ersten Pfeile 7 verdeutlichen skizzenhaft den Strahlengang von Strahlung, die ausgehend von dem der Strahlungsauskoppelfläche 21 der Leuchtdiode 20 gegenüberliegenden Bereich der Strahlungseintrittsfläche 1 auf den konkav gekrümmten Teilbereich 5 der Strahlungsaustrittsfläche 6 trifft. Die Strahlung wird hier von der Mitte der Strahlungsaustrittsfläche 6 zu den Randbereichen hin gebrochen. Auf diese Weise kommt es zu einer Umverteilung der Strahlung aus dem der Leuchtdiode 20 gegenüberliegenden Bereich der Strahlungsaustrittsfläche 6 zu den Seitenbereichen hin. Die von der Leuchtdiode 20 erzeugte Strahlung kann auf diese Weise homogen verteilt werden.

Strahlung, die auf die konvex gekrümmten Teilbereiche 4 der Strahlungsaustrittsfläche 6 trifft, wird zur Mitte der Strahlungsaustrittsfläche 6 hin gebrochen (siehe beispielsweise Pfeil 8). Dies sorgt unter anderem für einen scharfen Abfall der Beleuchtungsstärke am Rand des zu beleuchtenden Gebiets.

Die Seitenflächen 3a, 3b des optischen Elements sind nach Art eines der folgenden optischen Elemente geformt sein: Zusammengesetzter parabolischer Konzentrator (CPC - Compound Parabolic Concentrator), zusammengesetzter elliptischer Konzentrator (CEC - Compound Elliptic Concentrator), zusammengesetzter hyperbolischer Konzentrator (CHC - Compound Hyperbolic Concentrator). Alternativkönnten die Seitenflächen 3a, 3b Freiformflächen sein oder zumindest stellenweise durch ebene Fläche gegeben sein. Das optische Element 1 verjüngt sich in einem Schnitt senkrecht zu dem in Figur 2 gezeigten Schnitt in Richtung der Lichtquelle 20.

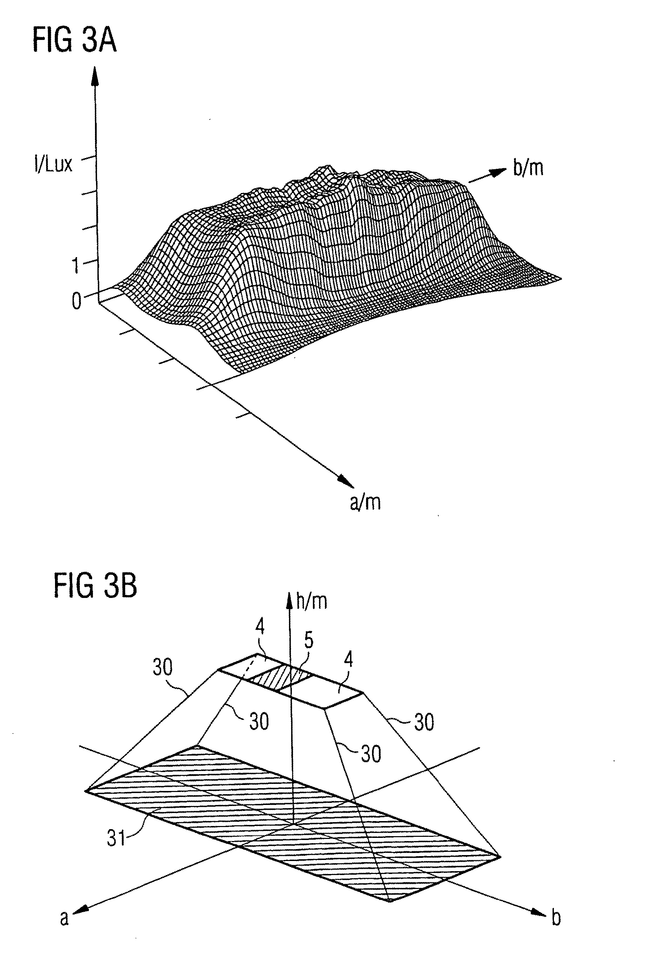

Eine Verwendung der beschriebenen Optik resultiert in der in Figur 3a gezeigten gemessenen Beleuchtungsstärke I. Figur 3a zeigt dabei die gemessene Beleuchtungsstärke I in Lux im vorgegebenem Gebiet 31, für eine Anordnung der Optik gemäß Figur 3b. Die Leuchtdiode ist hier in einer Höhe von h=2,5 m über dem vorgegebenen Gebiet 31 angeordnet. In Figur 3a ist gezeigt, dass das hier 2 m mal 8 m große Gebiet 31 im Wesentlichen homogen ausgeleuchtet ist. Die Beleuchtungsstärke I beträgt dabei im gesamten Gebiet 31 wenigstens 1 Lux. An den Rändern des Gebiets 31 fällt die Beleuchtungsstärke I steil ab. Die Beleuchtungsstärke I weist hier steil abfallende Flanken auf. Das ausgeleuchtete Gebiet ist dabei geometrisch zur Draufsicht auf die Strahlungsaustrittsfläche 6 ähnlich.

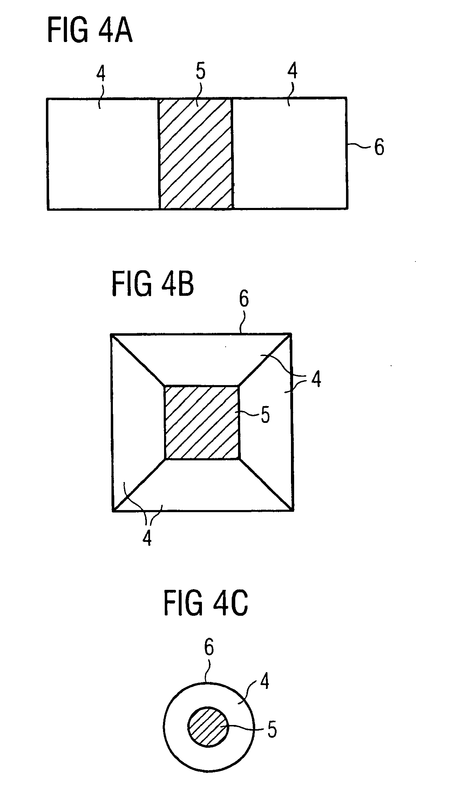

Die Figuren 4a, 4b und 4c zeigen mögliche Strahlungsaustrittsflächen 6 des optischen Elements. Je nach Größe und Form des auszuleuchtenden Gebiets kann die Strahlungsaustrittsfläche 6 des optischen Elements entsprechend angepasst werden.

Der konkav gekrümmte Bereich 5 ist gemäß Figur 4A von zwei konvex gekrümmten Teilbereichen umgeben. Alternativ wäre es denkbar, dass der konkav gekrümmte Bereich 5 von mehreren konvex gekrümmten Teilbereichen umgeben ist (Figuren 4B und 4C).

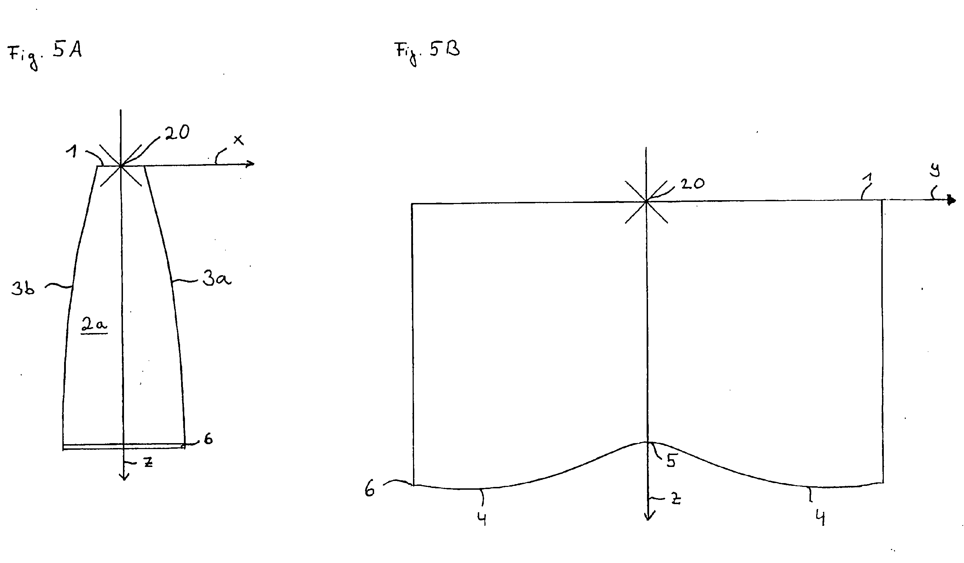

Figur 5A zeigt eine schematische Schnittdarstellung des optischen Elements in der Aufsicht auf die reflektierende Fläche 2a. Die Tabelle 1 gibt x- und z-Koordinaten von Punkten an, die auf der Seitenfläche 3a des optischen Elements liegen. Alle Werte sind dabei in Millimetern angegeben. Das optische Element ist achsensymmetrisch zur z-Achse, die senkrecht auf der Strahlungseintrittsfläche 1 des optischen Elements steht und durch das optische Element hindurch in Richtung Strahlungsaustrittsfläche 6 verläuft. Die x-Achse des optischen Elements verläuft quer zur Längsachse y des optischen Elements in der Strahlungseintrittsfläche 1.

**Tabelle 1:**

| x [mm] | z [mm] |
|---|---|
| 2.000 | 0.000 |
| 3.370 | -5.650 |
| 3.410 | -5.820 |
| 3.510 | -6.260 |
| 3.680 | -7.030 |
| 3.900 | -8.220 |
| 4.180 | -9.980 |
| 4.510 | -12.610 |
| 4.850 | -16.620 |
| 5.160 | -23.080 |

Figur 5B zeigt eine schematische Schnittdarstellung des optischen Elements entlang der Strahlungseintrittsfläche 1. Die y-Achse des optischen Elements verläuft in der Strahlungseintrittsfläche 1 und ist beispielsweise durch die Längsachse des optischen Elements gebildet. Tabelle 2 gibt y- und z-Koordinaten von Punkten die auf der Strahlungsaustrittsfläche 6 liegen an.

**Tabelle 2:**

| y [mm] | z [mm] |
|---|---|
| 0.000 | -20.270 |
| 0.140 | -20.270 |
| 0.270 | -20.270 |
| 0.410 | -20.280 |
| 0.540 | -20.290 |
| 0.680 | -20.300 |
| 0.810 | -20.320 |
| 0.950 | -20.340 |
| 1.080 | -20.370 |
| 1.220 | -20.400 |
| 1.350 | -20.430 |
| 1.350 | -20.430 |
| 1.710 | -20.530 |
| 2.080 | -20.650 |
| 2.450 | -20.770 |
| 2.820 | -20.920 |
| 3.200 | -21.070 |
| 3.590 | -21.230 |
| 3.990 | -21.390 |
| 4.400 | -21.560 |
| 4.810 | -21.720 |
| 5.230 | -21.880 |
| 5.660 | -22.050 |
| 6.100 | -22.210 |
| 6.550 | -22.370 |
| 7.010 | -22.520 |
| 7.470 | -22.670 |
| 7.940 | -22.810 |
| 8.420 | -22.950 |
| 8.910 | -23.080 |
| 9.410 | -23.200 |
| 9.910 | -23.320 |
| 10.430 | -23.430 |
| 10.950 | -23.530 |
| 11.470 | -23.620 |
| 12.000 | -23.700 |
| 12.540 | -23.770 |
| 13.090 | -23.820 |
| 13.640 | -23.870 |
| 14.190 | -23.900 |
| 14.750 | -23.920 |
| 15.320 | -23.930 |
| 15.890 | -23.930 |
| 16.460 | -23.910 |
| 17.040 | -23.880 |
| 17.610 | -23.830 |
| 18.190 | -23.760 |
| 18.770 | -23.680 |
| 19.350 | -23.580 |
| 20.000 | -23.580 |

Die Leuchtdiode 20 ist beim Ausführungsbeispiel der Figuren 5A und 5B im geometrischen Mittelpunkt der Strahlungseintrittsfläche 1 an den Koordinaten x = 0, y = 0 und z = 0 angeordnet.

Figur 3A zeigt die gemessene Beleuchtungsstärke für diese Anordnung der Leuchtdiode 20 an der Strahlungseintrittsfläche des optischen Elements gemäß dem Ausführungsbeispiel der Figuren 5A und 5B. Die Leuchtdiode 20 ist in diesem Ausführungsbeispiel eine Lichtquelle mit lambertscher Abstrahlcharakteristik. Die Lichtauskoppelfläche 21 der LED 20 hat einen Durchmesser von 2,5 mm.

Im Gegensatz zur Anordnung der Leuchtdiode 20, wie sie in Verbindung mit den Figuren 5A und 5B gezeigt ist, kann die Leuchtdiode 20 auch mit einem Spalt 23 zwischen Strahlungseintrittsfläche 1 und Strahlungsauskoppelfläche 21 angeordnet sein. In diesem Zusammenhang erweist sich eine Spaltbreite von maximal 500 µm als besonders vorteilhaft. Durch einen solchen zum Beispiel luftgefüllten Spalt 23 wird das Licht der LED 20 schon bei Durchtritt durch die Strahlungseintrittsfläche 21 leicht gebrochen. Dies führt zu einer Vorfokusierung des Lichtstrahls.

Diese Patentanmeldung beansprucht die Prioritäten der deutschen Patentanmeldungen 102004035127.9 und 102004042561.2, deren Offenbarungsgehalt hiermit durch Rückbezug aufgenommen wird.

Die Erfindung ist nicht durch die Beschreibung anhand der Ausführungsbeispiele beschränkt. Vielmehr umfasst die Erfindung jedes neue Merkmal sowie jede Kombination von Merkmalen, was insbesondere jede Kombination von Merkmalen in den Patentansprüchen beinhaltet, auch wenn dieses Merkmal oder diese Kombination von Merkmalen selbst nicht explizit in den Patentansprüchen oder Ausführungsbeispielen angegeben ist.

## Patentansprüche

1. Leuchtdiodenanordnung umfassend:
- ein optisches Element mit einer rechteckigen Strahlungseintrittsfläche (1) und einer Strahlungsaustrittsfläche (6), die auf der zur Strahlungseintrittsfläche gegenüberliegende Seite des optischen Elementes angeordnet ist, wobei die Strahlungsaustrittsfläche einen konkav gekrümmten Teilbereich (5) in der Mitte der Strahlungsaustrittsfläche (6) und zwei konvex (4) gekrümmte Teilbereiche aufweist die den konkav gekrümmten Teilbereich (5) seitlich einschließen, und
- wenigstens einer Leuchtdiode, wobei die Leuchtdiode so angeordnet ist, dass die Strahlungseintrittsfläche des optischen Elements der Leuchtdiode in einer Hauptabstrahlrichtung nachgeordnet ist, und zentriert zum konkav gekrümmten Teilbereich (5) angeordnet ist wobei seitlich am optischen Element reflektierende Flächen (2a,2b) angeordnet sind und senkrecht zu den reflektierenden Flächen (2a,2b) Seitenflächen (3a, 3b) zwischen der Strahlungseintrittsfläche (1) und der Strahlungsaustrittsfläche (6) angeordnet sind, deren Form einem der folgenden optischen Elemente entspricht sind: zusammengesetzter parabolischer Konzentrator, zusammengesetzter elliptischer Konzentrator, zusammengesetzter hyperbolischer Konzentrator, wobei sich der jeweilige Konzentrator zur Strahlungseintrittsfläche (1) hin verjüngt, und eine Draufsicht auf die Stralungsaustrittsfläche (6) rechteckig ist.

2. Leuchtdiodenanordnung nach Anspruch 1, bei dem das optische Element ein Material enthält, das einen Brechungsindex von wenigstens n = 1,3 aufweist.

3. Leuchtdiodenanordnung nach einem der obigen Ansprüche bei dem das optisches Element,
eines der folgenden Materialien enthält: Plexiglas, Glas, Polykarbonat, PMMI, PMMA, COC.

4. Leuchtdiodenanordnung nach einem der obigen Ansprüche, bei der die Leuchtdiode (20) wenigstens einen Leuchtdiodenchip in Dünnfilmbauweise aufweist.

5. Leuchtdiodenanordnung nach einem der obigen Ansprüche, bei der die Leuchtdiode (20) eine Leistungsaufnahme zwischen 1 W und 2 W aufweist.

6. Leuchtdiodenanordnung nach einem der obigen Ansprüche, bei der die Leuchtdiodenanordnung geeignet ist, eine Fläche (31) von wenigstens 16 m² mit einer mittleren Beleuchtungsstärke von wenigstens 1 Lux auszuleuchten.

7. Leuchtdiodenanordnung nach einem der obigen Ansprüche, bei der zwischen der Strahlungseintrittsfläche (1) des optischen Elements und der Strahlungsauskoppelfläche (21) der Leuchtdiode (20) ein Spalt (23) angeordnet ist.

8. Notbeleuchtung, aufweisend
eine Leuchtdiodenanordnung nach einem der Ansprüche 1 bis 7 und eine netzunabhängige Stromversorgung.

## Claims

1. Light-emitting diode arrangement comprising:
- an optical element having a rectangular radiation entrance surface (1) and a radiation exit surface (6) which is arranged on the side of the optical element opposite the radiation entrance surface, the radiation exit surface having a concavely curved subregion (5) in the middle of the radiation exit surface (6) and two convexly curved subregions (4) which laterally enclose the concavely curved subregion (5), and
- at least one light-emitting diode, the light-emitting diode being arranged such that the radiation entrance surface of the optical element is downstream of the light-emitting diode in a main direction of emission, and is arranged centred in relation to the concavely curved subregion (5),
reflecting surfaces (2a, 2b) being arranged laterally on the optical element, and there being arranged between the radiation entrance surface (1) and the radiation exit surface (6) perpendicular to the reflecting surfaces (2a, 2b), lateral surfaces (3a, 3b) whose form corresponds to one of the following optical elements: compound parabolic concentrator, compound elliptic concentrator, compound hyperbolic concentration, the respective concentrator tapering towards the radiation entrance surface (1), and a top view of the radiation exit surface (6) being rectangular.

2. Light-emitting diode arrangement according to Claim 1, in which the optical element contains a material which has a refractive index of at least n = 1.3.

3. Light-emitting diode arrangement according to one of the above claims, in which the optical element contains one of the following materials: Plexiglas, glass, polycarbonate, PMMI, PMMA, COC.

4. Light-emitting diode arrangement according to one of the above claims, in which the light-emitting diode (20) has at least one light-emitting diode chip of thin-film design.

5. Light-emitting diode arrangement according to one of the above claims, in which the light-emitting diode (20) has a power consumption of between 1 W and 2 W.

6. Light-emitting diode arrangement according to one of the above claims, in which the light-emitting diode arrangement is suitable for illuminating a surface (31) of at least 16 m² with a mean illuminance of at least 1 lux.

7. Light-emitting diode arrangement according to one of the above claims, in which a gap (23) is arranged between the radiation entrance surface (1) of the optical element and the radiation decoupling surface (21) of the light-emitting diode (20).

8. Emergency lighting having a light-emitting diode arrangement according to one of Claims 1 to 7 and a mains-independent power supply.

## Revendications

1. Système à diodes luminescentes comprenant :
un élément optique doté d'une surface rectangulaire (1) d'entrée de rayonnement et d'une surface (6) de sortie de rayonnement disposées sur le côté de l'élément optique situé face à la surface d'entrée de rayonnement,
la surface de sortie de rayonnement présentant une partie (5) à courbure concave et au milieu de la surface (6) de sortie de rayonnement, deux parties (4) à courbure convexe qui délimitent latéralement la partie (5) à courbure concave,
au moins une diode luminescente disposée de telle sorte que la surface d'entrée de rayonnement de l'élément optique soit disposée suite à la diode luminescente dans une direction principale d'émission et soit centrée par rapport à la partie (5) à courbure concave,
des surfaces réfléchissantes (2a, 2b) étant disposées latéralement sur l'élément optique et des surfaces latérales (3a, 3b) étant disposées entre la surface (1) d'entrée de rayonnement et la surface (6) de sortie de rayonnement perpendiculairement aux surfaces réfléchissantes (2a, 2b), leur forme correspondant à l'un des éléments optiques suivants : concentrateur parabolique assemblé, concentrateur elliptique assemblé, concentrateur hyperbolique assemblé, le concentrateur concerné se rétrécissant en direction de la surface (1) d'entrée de rayonnement, la surface (6) de sortie de rayonnement vue en plan étant rectangulaire.

2. Système à diodes luminescentes selon la revendication 1, dans lequel l'élément optique contient un matériau dont l'indice de réfraction n = au moins 1,3.

3. Système à diodes luminescentes selon l'une des revendications précédentes, dans lequel l'élément optique contient l'un des matériaux suivants : plexiglas, verre, polycarbonate, PMMI, PMMA, COC.

4. Système à diodes luminescentes dans lequel la diode luminescente (20) présente au moins une puce de diode luminescente constituée en film mince.

5. Système à diodes luminescentes dans lequel la puissance consommée par la diode luminescente (20) est comprise entre 1 W et 2 W.

6. Système à diodes luminescentes dans lequel le système de diode luminescente convient pour éclairer une surface (31) d'au moins 16 m² à une intensité moyenne d'éclairage d'au moins 1 lux.

7. Système à diodes luminescentes dans lequel un interstice (23) est prévu entre la surface (1) d'entrée du rayonnement de l'élément optique et la surface (21) de sortie du rayonnement de la diode luminescente (20).

8. Eclairage de secours présentant un système à diodes luminescentes selon l'une des revendications 1 à 7 et une alimentation en courant indépendante du réseau.
